Europäisches Patentamt

European Patent Office

Office européen des brevets

(11) Publication number: 0 417 961 A2

# EUROPEAN PATENT APPLICATION

(21) Application number: 90309683.2

(22) Date of filing: 04.09.90

(51) Int. Cl.⁵: H05K 7/18, H05K 7/14

(30) Priority: 14.09.89 GB 8920852

(43) Date of publication of application:
20.03.91 Bulletin 91/12

(84) Designated Contracting States:
DE FR IT

(71) Applicant: ORBITEL MOBILE
COMMUNICATIONS LIMITED
Western Road
Bracknell, Berkshire(GB)

(72) Inventor: Easteal, John Richard
6A Greenham Close
Woodley Reading, Berkshire(GB)
Inventor: Strachan, Mark Richard
41 Widend Drive
South Ascot, Buckinghamshire SL5 8BD(GB)
Inventor: Street, John Richard
56 Shefford Crescent
Wokingham, Berkshire(GB)

(74) Representative: Foster, David Martyn et al
MATHISEN MACARA & CO. The Coach
House 6-8 Swakeleys Road
Ickenham Uxbridge UB10 8BZ(GB)

(54) Racking system.

(57) A racking system for electrical equipment, the system comprising a plurality of racks (2) positioned one on top of the other and/or side by side, each rack (2) being adapted to receive a respective unit (4) of electrical equipment. The electrical equipment for each rack has on a front side (10), which is in use positioned at a front face of the racking system, an array of electrical connectors (12). A cover arrangement at the front face provides a protective cover (30) for the arrays (12) of connectors and defines a space between the cover arrangement and front side to permit the fixing of connectors and associated cables for the interconnection of connector means between the arrays (12). The cover arrangement also defines a cavity along one or both sides and/or the top and/or the bottom of each rack to permit the fixing of connectors and associated cables between units (4) of electrical equipment positioned on different racks (2).

Figure 5

## RACKING SYSTEM

This invention relates to racking systems. In particular the invention relates to racking systems for electrical equipment.

A common form of known racking system consists of a cabinet which houses racks and subracks which, in turn, carry electrical equipment in the form of plug-in-units and printed circuit board assemblies. Many of the racks and subracks have integral wiring and consequently can be removed as complete modules.

In accordance with functional and electronic specifications the individual units or assemblies housed by the system need to be connected both together and to external electrical sources. This usually involves substantial wiring and cable management facilities which normally reside towards the rear of the cabinet and thus access to the side or rear of the cabinet is required for ease of maintenance of the units or assemblies. There is also a general requirement to provide some form of indication of the operational status of the units or assemblies by means of indicator lights which are usually located towards the front of the cabinet on the front panels of the individual units or assemblies, where additional cable connections are usually necessary. In order to retain a tidy appearance to the cabinet a hinged panel or door is usually fitted to the front of the cabinet.

A problem with this type of known racking system is that it is necessary to gain access both to the rear and to the front of the cabinet in order to carry out maintenance or replacement of the units or assemblies carried by the system; such access may be difficult where, as is usually the case, space is limited. Furthermore, it can be difficult to remove individual units or assemblies without disturbing the electrical connections to the remaining units or assemblies.

It is an object of the invention to provide a racking system wherein at least some of the problems inherent in known systems are at least alleviated.

According to a first aspect of the present invention there is provided a racking system for a plurality of modules of electrical equipment, each module carrying on one face an array of electrical connector means, the system comprising a plurality of racks positioned in a stacked configuration, each rack being adapted to receive a respective module, the system including a cover arrangement at the front face of the system effective to define a cavity between the cover arrangement and each said one face to permit the fitting of electrical connectors and associated cables so as to enable the interconnection of connector means between the arrays, the cover arrangement also defining cavities along at least one perimeter surface of each rack to enable the directing of connectors and associated cables between modules positioned on different racks.

The front face of the system is preferably designed to receive the modules of electrical equipment into the system.

Thus in a system in accordance with the invention, all electrical connections and handling of the electrical equipment may be carried out from the front face of the system, thus permitting the placement of the racking system in a confined space. However, if necessary in certain situations, electrical connections can be made at the rear face of the equipment, and/or the equipment placed in the racks from the rear face of the system.

Preferably the front cover arrangement includes a plurality of cover plates, which can be of any material, but for aesthetic reasons are preferably transparent or translucent, each plate covering a respective rack. A rib member is preferably provided for each rack, the rib member being disposed either on the rack or arranged to be carried along an edge of the electrical equipment. Each rib member may carry a locating mean arranged to hold an edge of a cover plate respective. As preferred the rib member comprises one or more colinear sections of for example aluminium extrusion, each section being mounted on the first side of a respective unit of electrical equipment. Thus each rib section may serve as a handle for removal and insertion of the electrical equipment into the rack, and also may carry at least some of the indicator lights for the system.

The front cover arrangement may include a plurality of cover plates, each plate covering a respective rack and being located in position between two opposing ribs, each rib upstanding either from said first side of a module of the electrical equipment or from the respective rack.

The front cover arrangement preferably includes at least one, preferably a pair, of movable side pieces, extending along a side edge or top/bottom edge of a plurality of adjacent racks in order to define a duct behind each side piece extending across the plurality of racks in order to enable wiring to be led between adjacent racks. As preferred the side pieces are hinged and are movable to/and lockable in a closed position in which they overlap the front cover plates in order to lock the whole front face of the racking system to prevent unauthorised entry.

According to a second aspect of the present invention there is provided an electrical apparatus comprising a racking system and a plurality of modules of electrical equipment, the system comprising a plurality of racks positioned in a stacked configuration, each rack being adapted to receive a respective module, each module having a first face, which is in use positioned at a front face of the racking system, an array of connector means being carried on the first face, the system including at the front face of the system a cover arrangement effective to define a cavity between the cover arrangement and each said one face to permit the fitting of electrical connectors and associated cables so as to enable the interconnection of connector means between the arrays, the cover arrangement also defining cavities along at least one perimeter surface of each rack to enable the directing of connectors and associated cables between modules positioned on different racks.

One embodiment of a racking system in accordance with the invention will now be described, by way of example only, with reference to the accompanying drawings wherein:-

Figure 1 is a front view of a racking system for electrical equipment according to the present invention;

Figure 2 is a side view of the equipment of Figure 1, partly in cross-section;

Figure 3 is an enlarged view of the cross-sectional detail of Figure 2;

Figure 4 is a partial cross-sectional view of the system along the line 4-4 of Figure 1 showing one side piece hinged to an open position and another side piece hinged to a closed position; and

Figure 5 is a perspective view of the front face of a rack of electrical equipment for fixing in the racking system.

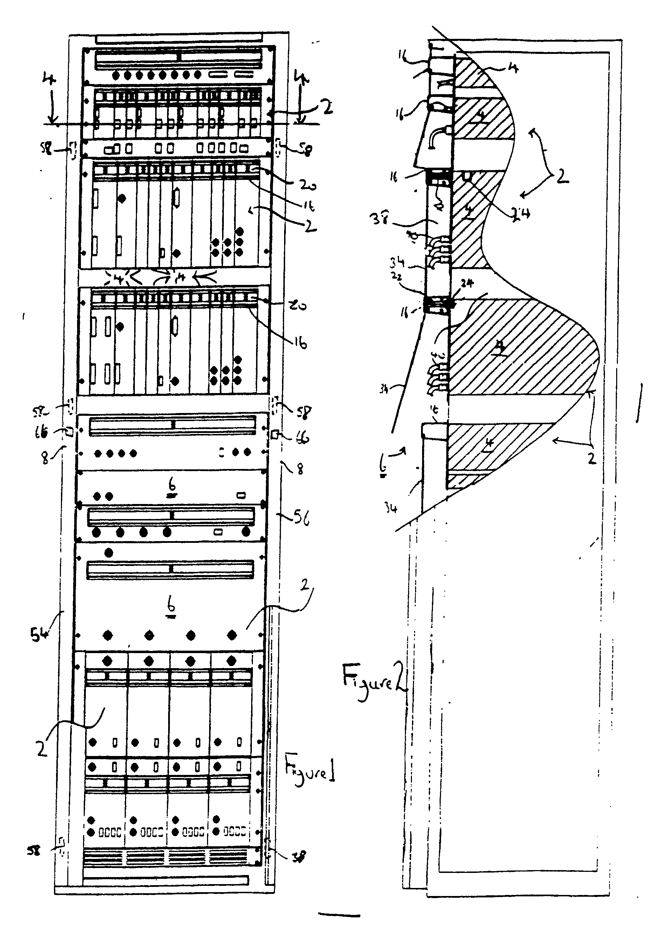

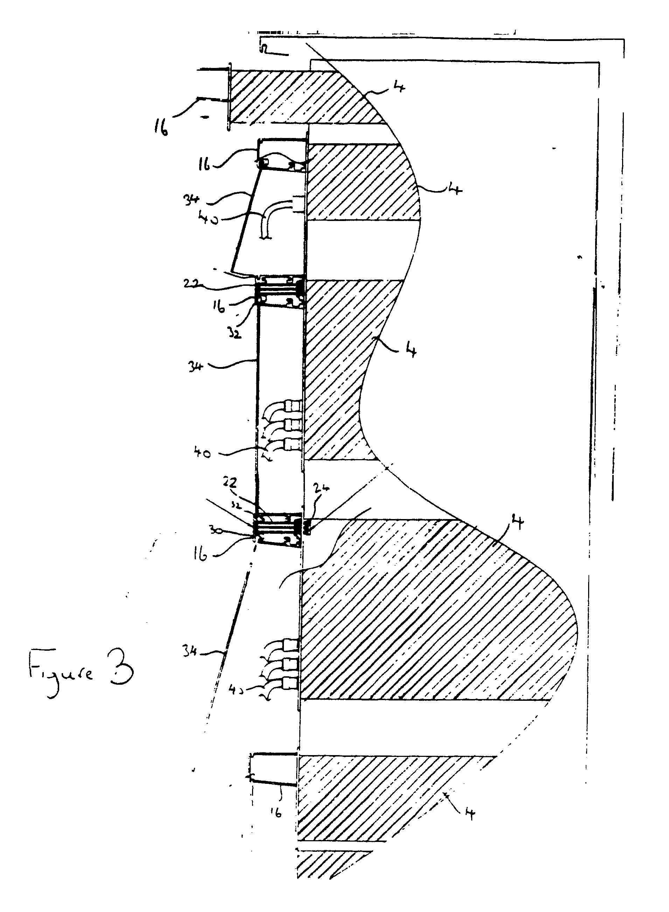

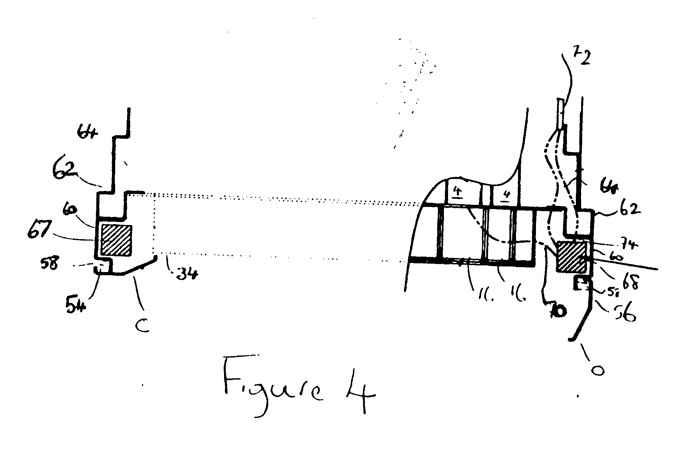

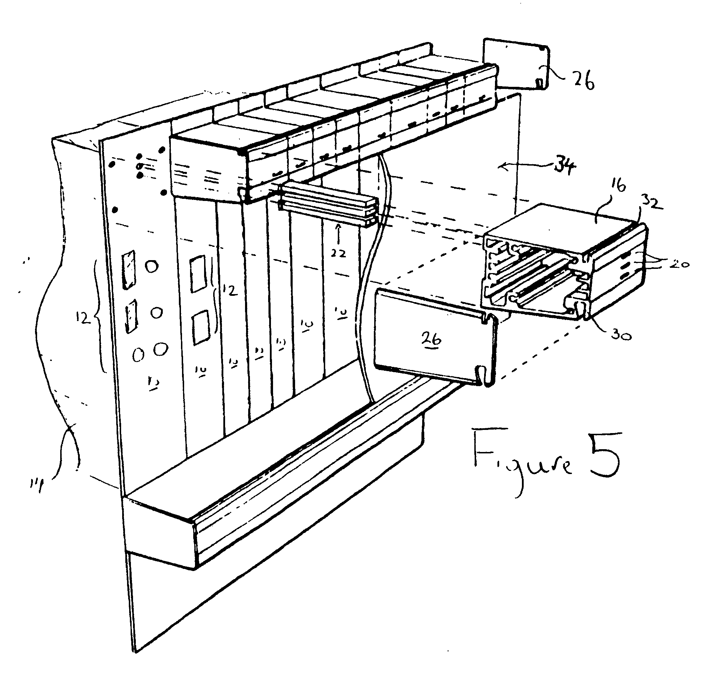

Referring firstly to Figures 1 and 2 of the drawings the racking system shown comprises a plurality of racks 2 for units 4 of electrical equipment. The racks 2 are disposed in a stacked configuration one on top of the other so as to provide a front face 6 with vertically extending side edges 8. As best seen in Figure 5, each unit of electrical equipment has a front side 10 comprising a face plate with an array of connectors 12 disposed thereon. The width of the face plate is an industry standard width, being an integral multiple of a basic unit. The major part of the electrical equipment is disposed in a housing 14, which may itself comprise an assembly of printed circuit boards, extending behind the face plate. Mounted along the top edge of the face plate is a section 16 of aluminium extrusion forming an upstanding rib. This rib serves a variety of purposes, including that of a handle for removal and insertion of each unit 4 into and out of the associated rack 2. In addition, as can be seen in Figures 1 and 2, the rib carries on its front face a plurality of indicator devices 20, which may take the form of indicator lights, meters etc, and may be coupled via light pipes and/or optical fibres 22 extending through the hollow interior of the rib to various light sources and sources of meter signals 24 on the front face 10 of the equipment or within housing 14. Alternatively the indicator lights, meters etc. may incorporate their own sources. As can best be seen in Figures 1 and 5 when an array of units 4 is mounted within a rack 2, the ribs 16 will be arranged in a co-linear array to provide a continuous rib extending along the top edge of the rack. The ends of the continuous rib are closed by end pieces 26. The bottom edge of the rib has a relatively wide and deep slot 30 and the top edge of the rib has a narrower and shallower groove 32. Associated with each rack is a cover plate 34 of smoked or translucent plastic or glass which is inserted into the slots 30,32 carried by a pair of opposing ribs, by pushing the top edge of the plate 34 firmly into deep slot 30 and then aligning the plate with the lower slot 32 and allowing the plate to drop into slot 32, the dimensions of the plate being such that plate 34 is then located in both slots 30,32. In this position, cover plate 34 provides a space 36 therebehind for accommodating the various connectors 38 and wiring 40 for coupling selected connectors within the arrays 12.

Referring now particularly to Figure 4, disposed along the vertical edges of the front face of the racks is a pair of opposing side members 54,56, the side members being hinged as at 58 to front side wall sections 60 of the racking system. The side wall sections 60 have a generally U-shape, and are welded to main side wall sections 62 which are angled as shown to provide vertical ducts 64.

Each side member 54,56 extends along a plurality of adjacent racks and has in cross section an angled form. The hinged members 54,56 are movable between a closed position C and an open position O. In the closed position the free edge of the side members overlaps the cover pieces 34, and locks 66 are provided so that the side pieces can be locked in the closed position in order to secure the whole of the front side of the racking system against unauthorised entry. In addition, in the closed position, the side members provide therebehind, vertically extending ducts 68 for routing cable 70 between the various racks. Thus there are provided on each side of the racking system two vertical ducts 64,68 for cable management to permit cables to be led between racks. Ducts 64 are intended for semi-permanent cables, and a power bus bar 72 is provided for coupling to the cables. Apertures 74 are provided to permit communication between ducts 64 and 68 to permit the passage of wiring from the racks. Ducts 68 are intended for cables which may be required to be changed frequently.

In the open position O of the side members 54,56, the front cover pieces 34 may be released from the ribs to enable access to the units of electrical equipment 4 and to enable their removal or insertion.

There has thus been shown and described a racking system for electrical equipment which enables access, interconnections and maintenance to be carried out from the front of the racking system without requiring personnel also to have access to the rear of the system, thus permitting use of the system in confined spaces. The racking system is attractive in appearance and has various features indicated above which permit a neat and inexpensive solution to the problems associated with using racking systems in confined spaces.

Various modifications and variations may be made to the system as shown in the drawings. For example, racks may be stacked side by side instead or in addition to being stacked vertically above one another, and the side pieces may extend along the top and bottom edges of the racks rather than as shown vertically extending along the side edges of the racks. The number of electrical units within each rack will depend on the circumstances and may be a single unit for example a power supply or may comprise a number of separate units, each unit having one or more circuit cards.

Thus a feature of the system is to bring all the cable management towards the front of the cabinet, eliminating the need for access to the rear or side of the cabinet. All interconnections between the racking elements and external sources can, potentially, be facilitated towards the front of the cabinet. To disguise the abundance of connectors and cables a number of small panels, that complement the sizes and displacement of the racking elements, are fitted.

The main cable trunking runs in the vertical plane along either side of the cabinet and is concealed by hinged covers that run the length of the cabinet. Unlike a hinged door or panel which usually conceals the whole face of the cabinet, these hinged covers conceal the localised area to either side, therefore the access is greatly improved and space requirements minimised. These covers can also be locked to secure the panels which, in turn, prevents unauthorised access to the racking elements.

The cabinet has an overall neat and tidy appearance which is achieved by the introduction of the modular upstanding ribs that are connected to the electrical equipment carried by the racking system. These upstanding ribs have several functions.

Firstly the ribs act as handles for removing the units of electrical equipment from the racking system. Furthermore, the ribs provide locating forms into which the panels can be retained, the panels enabling the system to be made tamper and vermin proof. A cavity is defined by the ribs between the front faces of the racking elements and the panels, which enables all cabling and connections to be concealed. Finally, the ribs provide a suitable surface for carrying status indicators such that the status indicators can be viewed proud of the panels.

The installed racking elements and their associated upstanding ribs create horizontal strips across the cabinet which appear at a variety of heights depending on the configuration in respect of the particular application. When the panels are in place only the front face of the upstanding ribs which also accommodates any necessary status indicators, are visible. Therefore the completed cabinet has a smart overall appearance with only the covers, panels and the front facia of the upstanding ribs carrying the status indicators, exposed.

This format allows the service engineer to see if the unit is functioning correctly, without opening a door or touching it, by interpreting the information from the status indicators. If there is a fault the engineer simply opens the appropriate covers and removes the panels either side of the suspect racking elements. The individual racking units and their interconnections. are exposed which can then be removed or replaced to repair the system.

It will be appreciated that it is a particular feature of the invention that the electrical cables are parallel to the surfaces of the units of the electrical equipment so as to allow the insertion or removal of a particular unit without disturbing the cables for adjacent units. Such an arrangement necessitates the use of electrical cabling which is capable of sharp $90°$ bends. This may be achieved by the use of expanded foam cable, as is manufactured, for example by W. L. Gore (UK) Limited. Alternatively, ribbon or film cables may be used.

It will also be appreciated that racking systems in accordance with the invention may house a wide range of electrical equipment, this usually, but not always, taking the form of electronic assemblies.

## Claims

1. A racking system for a plurality of modules (4) of electrical equipment, each module (4) carrying on one face an array (12) of electrical connector means, the system comprising a plurality of racks (2) positioned in a stacked configuration, each rack (2) being adapted to receive a respective module (4), the system being characterised in that it includes a cover arrangement at the front face of the system effective to define a cavity between the cover arrangement and each said one face to permit the fitting of electrical connectors (38) and associated cables (40)so as to enable the interconnection of connector means (38) between the arrays (12), the cover arrangement also defining cavities along at least one perimeter surface of each rack (2) to enable the directing of connectors (38) and associated cables (40) between modules positioned on different racks (12).

2. A racking system according to claim 1 in which the front face of the system is designed to receive the modules (4) of electrical equipment into the system.

3. A racking system according to either of the preceding claims wherein the cover arrangement includes a plurality of cover plates (34), each plate (34) covering a respective rack (2) and being located in position between two opposing upstanding ribs (16).

4. A racking system according to claim 3 wherein each rib (16) is carried by a respective one of the modules (4) of electrical equipment.

5. A racking system according to claim 3 wherein each rib (16) is carried by a respective one of the racks (2).

6. A racking system according to claim 3 wherein the front cover arrangement includes one or more movable side pieces (54,56) extending along a common edge of a plurality of adjacent racks (2) in order to define a duct extending behind each side piece, so as to enable wiring to be led between adjacent racks (2), the or each side piece (54,56) being movable to a closed position in which it overlaps a cover plate positioned over the front face of the racks in order to secure the front cover arrangement in a closed position.

7. A racking system according to any one of claims 3 to 5 wherein the cover plates (34) are formed of at least partially light transmissive material.

8. A racking system according to any one of claims 3 to 7 wherein each rib (16) is formed of a metallic extrusion.

9. A racking system according to claim 8 in which the extrusion is a hollow aluminium extrusion.

10. A racking system according to any one of the preceding claims when dependent on claim 3 wherein status indicator lights (20) are mounted in the surface of each rib (16), the lights being connectable via light directing means (22) to sources (24) of light within the modules (4) of electrical equipment.

11. A racking system according to any one of the preceding claims when dependent on claim 3 wherein the ribs (16) associated with racks (2) positioned side by side in the system are co-linear.

12. A racking system according to claim 6 wherein each side piece (54,56) is hinged in order to pivot between said closed position and an open position in which the cover plates (34) can be removed.

13. A racking system according to claims 6 to 12 wherein each side piece (54,56) is of dimensions such that it overlaps only an edge portion of the cover plates (34).

14. A racking system according to claims 6 to 12 wherein the side pieces (54,56) are lockable into a closed position.

15. An electrical apparatus comprising a racking system and a plurality of modules (4) of electrical equipment, the system comprising a plurality of racks (2) positioned in a stacked configuration, each rack (2) being adapted to receive a respective module (4), each module (4) having a first face, which is in use positioned at a front face of the racking system, an array (12) of connector means being carried on the first face, the electrical apparatus being characterised in that the system includes at the front face of the system a cover arrangement effective to define a cavity between the cover arrangement and each said one face to permit the fitting of electrical connectors (38) and associated cables (40) so as to enable the interconnection of connector means (38) between the arrays, the cover arrangement also defining cavities along at least one perimeter surface of each rack (2) to enable the directing of connectors (38) and associated cables (40) between modules positioned on different racks (2).

Figure 1

Figure 2

Figure 3

Figure 4

Figure 5